(19) **Europäisches Patentamt / European Patent Office / Office européen des brevets**

(11) **EP 2 197 106 B1**

(12) **FASCICULE DE BREVET EUROPEEN**

(45) Date de publication et mention
de la délivrance du brevet:
**12.10.2011 Bulletin 2011/41**

(51) Int Cl.:
**H03H 9/02** *(2006.01)*

(21) Numéro de dépôt: **09177883.7**

(22) Date de dépôt: **03.12.2009**

(54) **Réseau de résonateurs couplés, filtre passe-bande et oscillateur**

Netzwerk aus gekoppelten Resonatoren, Bandpassfilter und Oszillator

Array of coupled resonators, bandpass filter and oscillator

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**

(30) Priorité: **09.12.2008 FR 0858383**

(43) Date de publication de la demande:
**16.06.2010 Bulletin 2010/24**

(73) Titulaire: **Commissariat à l'Énergie Atomique
et aux Énergies Alternatives
75015 Paris (FR)**

(72) Inventeurs:
• **Kharrat, Chady**
  **38590 Sillans (FR)**
• **Colinet, Eric**
  **38240 Meylan (FR)**

(74) Mandataire: **Bonnet, Michel
Cabinet Bonnet
93, Rue Réaumur - Boîte 10
75002 Paris (FR)**

(56) Documents cités:
**US-A- 3 440 574       US-A1- 2001 030 489
US-A1- 2005 140 467    US-A1- 2006 125 576
US-B1- 6 236 281**

**Description**

La présente invention concerne un réseau de résonateurs couplés comportant des moyens de fourniture d'un signal électrique d'entrée et des moyens d'excitation électrique de N résonateurs couplés du réseau à l'aide de ce signal électrique d'entrée. Elle concerne également un filtre passe-bande pouvant par exemple être utilisé en tant que filtre RF (pour Radio Fréquence) et un oscillateur comportant un tel réseau de résonateurs couplés.

Elle s'applique notamment au domaine des télécommunications, pour la conception de filtres sélectifs, ou plus généralement au domaine des équipements électroniques, pour la conception d'oscillateurs formant des bases de temps pour cadencer une unité de calcul ou pour assurer une démodulation de signaux.

Un résonateur excitable par un signal électrique est en effet un dispositif électrique ou électromécanique défini principalement par sa fréquence de résonance $f_0$ et son facteur de qualité Q lié aux pertes énergétiques du résonateur. La fréquence de résonance et le facteur de qualité dépendent des paramètres géométriques et de la nature des matériaux utilisés dans le cas d'un résonateur électromécanique, ou des valeurs de ses composants de type R, L ou C dans le cas d'un résonateur électrique. Un tel résonateur peut donc être utilisé en boucle ouverte pour réaliser un filtrage passe-bande autour de sa fréquence de résonance, la bande passante étant d'autant plus étroite que le facteur de qualité est élevé. Il peut aussi être utilisé en boucle fermée, à l'aide d'un circuit électronique de rétroaction assurant son oscillation en générant, à partir du signal fourni par le résonateur, un signal capable d'exciter le résonateur sur sa fréquence de résonance $f_0$.

Un réseau de résonateurs couplés est formé de plusieurs résonateurs couplés entre eux mécaniquement (dans le cas de résonateurs électromécaniques) ou électriquement (dans le cas de résonateurs électriques) de sorte que l'excitation de l'un d'entre eux provoque la vibration mécanique ou l'oscillation électrique de l'ensemble des résonateurs couplés ayant au moins un degré de liberté dans ce réseau. Ces réseaux de résonateurs couplés permettent d'envisager des fonctions de traitement de signaux présentant une meilleure puissance et de meilleures performances que lorsque l'on utilise un résonateur seul. Par exemple, utilisés pour former des filtres, ils permettent d'obtenir une bande passante élargie.

Différents types de résonateurs excitables par un signal électrique sont connus et peuvent être utilisés pour former un tel réseau. Par exemple, les résonateurs à ondes acoustiques de surface, dits résonateurs SAW (de l'Anglais « Surface Acoustic Wave »), à ondes acoustiques de volume, dits résonateurs BAW (de l'Anglais « Bulk Acoustic Wave »), ou à cristal de quartz sont des résonateurs électromécaniques dont les principaux inconvénients sont leur taille relativement importante et leur implémentation hors puce électronique entraînant des connexions qui introduisent des valeurs parasites et du bruit et qui les rendent encombrants.

Pour résoudre ces problèmes d'encombrement et d'intégration, il est préférable d'utiliser des résonateurs électromécaniques de type NEMS (de l'Anglais « Nano Electro Mechanical Systems ») ou MEMS (de l'Anglais « Micro Electro Mechanical Systems »), ou des résonateurs électriques de type R, L, C offrant la possibilité de fabriquer le réseau de résonateurs collectivement par des techniques issues de la microélectronique. Les résonateurs NEMS/MEMS en particulier présentent un encombrement réduit et une faible consommation. Ils permettent en outre d'obtenir des hautes fréquences de résonance et des facteurs de qualité très élevés. Enfin, ils sont simples à réaliser et peuvent être intégrés avec des éléments électroniques de traitement de données sur une même puce ou carte électronique.

Concrètement, le couplage mécanique entre deux résonateurs NEMS/MEMS est réalisé à l'aide d'un pont mécanique plus ou moins rigide, tandis que le couplage électrique entre deux résonateurs électriques R, L, C peut être réalisé à l'aide d'une capacité ou d'une inductance mutuelle.

Le document de S. Lee et C. Nguyen intitulé « Mechanically-Coupled Micromechanical Resonator Arrays for Improved Phase Noise », 2004 IEEE International Ultrasonics, Ferroelectrics, and Frequency Control Joint 50th Anniversary Conference, décrit un réseau de résonateurs couplés mécaniquement en technologie MEMS.

Ce réseau est constitué de résonateurs électromécaniques de type plaque couplés mécaniquement dont le signal de sortie est relié à un étage de gain. Le signal de sortie de cet étage de gain est lui-même rebouclé sur le système d'actionnement commun à tous les résonateurs pour former un oscillateur. Cette architecture particulière en réseau permet d'obtenir un oscillateur globalement moins bruité avec une résistance motionnelle la plus faible possible.

Le document de S. Li, Y. Lin, Z. Ren et C. Nguyen intitulé « An MSI Micromechanical Differential Disk-array Filter », Dig. Of Tech. Papers, 14th International Conference on Solid-State Sensors and actuators (Transducers '07), Lyon, France, 11-14 Juin 2007, pages 307-311, décrit un autre réseau de résonateurs couplés mécaniquement en technologie MSI (de l'Anglais « Medium-Scale Integrated »).

Ce réseau disposé en matrice est constitué de résonateurs électromécaniques de type disque couplés mécaniquement par des ponts dont les longueurs s'expriment en fractions de la longueur d'onde de résonance. Comme précédemment, cette architecture permet d'obtenir une faible résistance motionnelle. Elle permet en outre de supprimer une partie des modes résonants non souhaités du réseau.

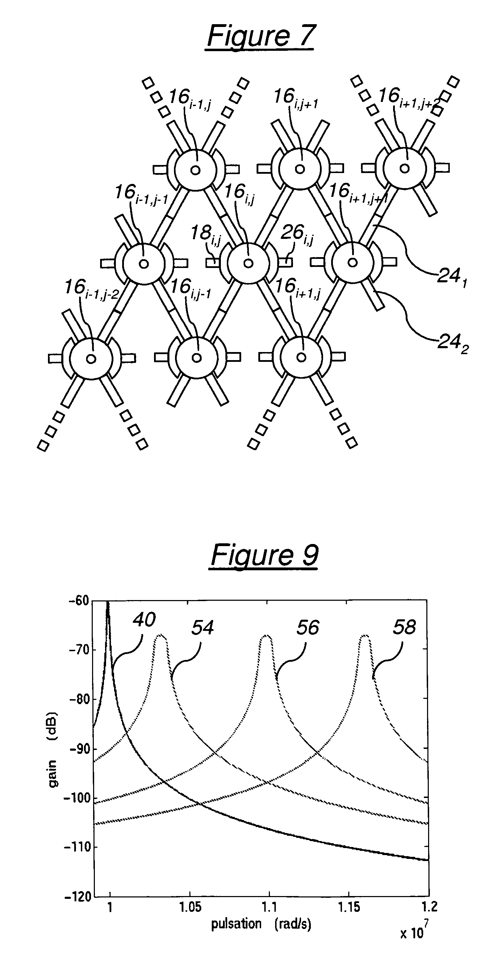

Le document US 2001/030489 A1 divulgue un réseau de résonateurs couplés comprenant des moyens de fourniture d'un signal électrique d'entrée (fig. 9, 20).

Néanmoins, ces architectures ne permettent pas d'ajuster la fréquence centrale ou la bande passante du résonateur global, la configuration de l'actionnement des résonateurs étant fixée à l'avance par l'emplacement des actionneurs pour accentuer au moins un des modes. Toutefois ceci est fait sans supprimer complètement les autres modes qui sont simplement fortement atténués. Ainsi dans une application de base de temps en présence de fortes dispersions sur les fréquences de résonance de chaque résonateur, il est impossible avec les architectures précitées de corriger efficacement ces dispersions.

Une architecture permettant d'ajuster la bande passante d'un filtre utilisant un réseau de résonateurs couplés est décrite dans le document de H. Chandrahalim et S. Bhave intitulé « Digitally-tunable MEMS filter using Mechanically-Coupled Resonator Array », 21 st IEEE International Conference on Micro Electro Mechanical Systems, Tucson, Arizona, USA, 13-17 janvier 2008.

Plus précisément, ce filtre est constitué d'un réseau de quatre résonateurs couplés en série dont seul le premier est connecté à une électrode d'excitation et seul le dernier est connecté à une électrode de détection. En commutant en outre l'un ou plusieurs des résonateurs couplés du réseau sur une tension de polarisation prédéterminée on peut sélectionner un mode de fonctionnement particulier du filtre parmi trois modes possibles dont un mode en bande large, un mode en bande basse et un mode en bande haute. Cet ajustement est cependant assez sommaire et peu souple.

Il peut ainsi être souhaité de prévoir un réseau de résonateurs couplés qui permette de s'affranchir des problèmes et contraintes précités.

L'invention a donc pour objet un réseau de résonateurs couplés comportant des moyens de fourniture d'un signal électrique d'entrée et des moyens d'excitation électrique de N résonateurs couplés du réseau à l'aide de ce signal électrique d'entrée. Dans ce réseau de résonateurs couplés, les moyens d'excitation électrique comportent :

- pour chacun de ces N résonateurs couplés :

  ■ des moyens d'actionnement raccordés aux moyens de fourniture du signal électrique d'entrée pour un actionnement de ce résonateur couplé en fonction du signal électrique d'entrée, et
  ■ des moyens d'amplification d'entrée à gain variable de l'actionnement de ce résonateur couplé propres à ce résonateur couplé,

- des moyens de commande d'un réglage spécifique du gain variable de chacun des moyens d'amplification d'entrée.

Ainsi, en pondérant différemment les excitations des différents résonateurs du réseau, il est possible de sélectionner une fréquence centrale de résonance et la bande passante du réseau de résonateurs. En disposant en outre de moyens pour régler dynamiquement cette pondération à l'aide de moyens d'amplification à gains variables commandés, on obtient un réseau de résonateurs dont la fréquence centrale de résonance et la bande passante sont réglables dynamiquement. Grâce à ce simple réglage, il est alors possible d'envisager des applications performantes de filtrage à bande passante ajustable ou d'oscillation à résonance ajustable.

De façon optionnelle, chaque résonateur comporte au moins un élément vibrant choisi parmi l'un des éléments de l'ensemble constitué d'un élément de type poutre vibrant en flexion, d'un élément de type disque, plaque ou poutre vibrant en volume et d'au moins un nano fil.

De façon optionnelle également, les résonateurs couplés sont des résonateurs électromécaniques de type NEMS ou MEMS et les moyens d'actionnement et d'amplification d'entrée à gain variable de chacun desdits N résonateurs couplés comportent une électrode d'excitation électrostatique dont la tension de polarisation est réglable par les moyens de commande.

De façon optionnelle également, ce réseau de résonateurs étant générateur de N modes de résonance différents à N fréquences modales différentes, tout signal vectoriel résultant de N signaux électriques fournis par lesdits N résonateurs couplés en réponse à une excitation à l'aide du signal électrique d'entrée pouvant être exprimé en tant que combinaison linéaire de N vecteurs modaux prédéterminés exprimant chacun la réponse desdits N résonateurs couplés dans l'un des N modes de résonance, les moyens de commande sont conçus pour régler sélectivement la valeur des N gains variables des moyens d'amplification d'entrée en fonction des composantes de l'un des N vecteurs modaux, notamment proportionnellement à ces composantes.

De façon optionnelle également, un réseau de résonateurs couplés selon l'invention peut en outre comporter :

- pour chacun de ces N résonateurs couplés, des moyens de détection d'une réaction de ce résonateur couplé, en réponse à l'excitation électrique des N résonateurs couplés par le signal électrique d'entrée, et de transformation de cette réaction en un signal électrique intermédiaire,
- des moyens de regroupement des signaux électriques intermédiaires pour former un signal électrique de sortie,

et les moyens de détection et de transformation de chacun de ces N résonateurs couplés sont associés à des moyens d'amplification de sortie à gain variable du signal intermédiaire qu'ils fournissent propres à ce résonateur couplé, ce gain variable étant spécifiquement réglable par les moyens de commande.

De façon optionnelle également, les moyens de détection et de transformation et les moyens d'amplification de sortie à gain variable de chacun desdits N résonateurs couplés comportent une électrode de détection capacitive dont la tension de détection est réglable par les moyens de commande.

De façon optionnelle également, les moyens de commande sont conçus pour fixer la valeur des gains variables des moyens d'amplification de sortie de en fonction des composantes du vecteur modal sélectionné pour fixer la valeur des gains variables des moyens d'amplification d'entrée, notamment proportionnellement à ces composantes.

De façon optionnelle également, un réseau de résonateurs couplés selon l'invention peut en outre comporter une charge capacitive connectée aux moyens de regroupement pour recevoir un courant transmis par ces moyens de regroupement et configurée pour que la tension à ses bornes soit représentative du signal électrique de sortie.

L'invention a également pour objet un filtre passe-bande à fréquence centrale ajustable comportant un réseau de résonateurs couplés tel que défini précédemment, conçu pour recevoir un signal à filtrer en tant que signal électrique d'entrée du réseau de résonateurs.

L'invention a également pour objet un oscillateur à fréquence d'oscillation ajustable comportant un réseau de résonateurs couplés tel que défini précédemment et un circuit de rétroaction pour la fourniture du signal électrique d'entrée en fonction du signal électrique de sortie du réseau de résonateurs.

L'invention sera mieux comprise à l'aide de la description qui va suivre, donnée uniquement à titre d'exemple et faite en se référant aux dessins annexés dans lesquels :

- la figure 1 représente schématiquement la structure générale d'un réseau de résonateurs couplés à une dimension selon un premier mode de réalisation de l'invention,
- la figure 2 représente un modèle mécanique équivalent du réseau de résonateurs couplés de la figure 1,
- les figures 3a, 3b, 3c illustrent graphiquement des valeurs de gains applicables par des moyens de commande du réseau de résonateurs couplés de la figure 1,
- les figures 4a et 4b illustrent graphiquement différentes réponses fréquentielles possibles du réseau de résonateurs couplés de la figure 1,
- la figure 5 représente schématiquement la structure générale d'un oscillateur selon un mode de réalisation de l'invention,
- la figure 6 représente schématiquement un circuit équivalent d'un circuit de lecture d'un signal de sortie fourni par l'oscillateur de la figure 5,
- la figure 7 représente schématiquement la structure générale d'un réseau de résonateurs couplés à deux dimensions selon un second mode de réalisation de l'invention,
- la figure 8 représente un modèle mécanique équivalent du réseau de résonateurs couplés de la figure 7, et
- la figure 9 illustre graphiquement différentes réponses fréquentielles possibles du réseau de résonateurs couplés de la figure 7.

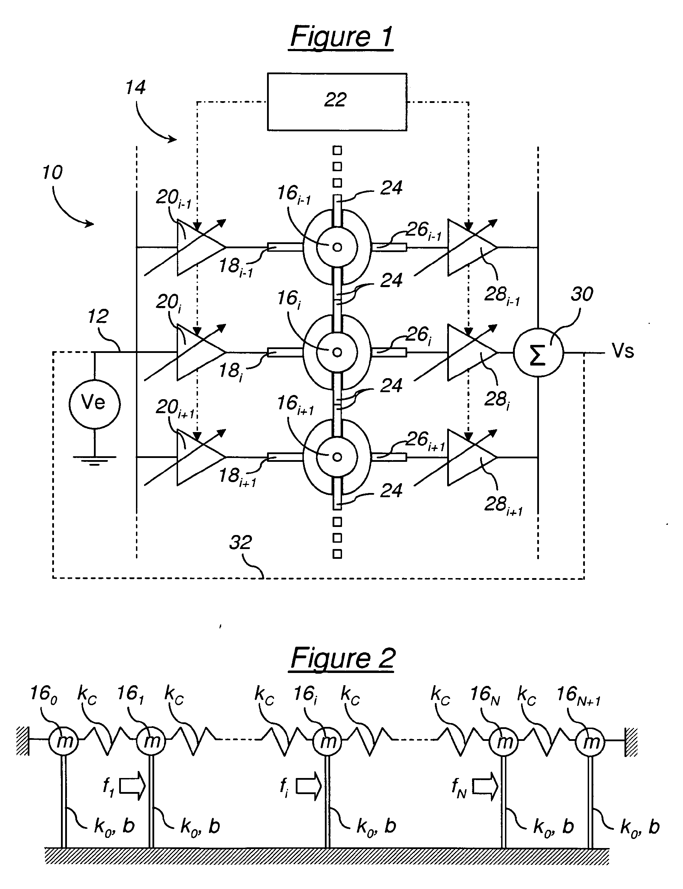

Le réseau 10 de résonateurs couplés représenté sur la figure 1 comporte des moyens 12 de fourniture d'un signal électrique d'entrée Ve et des moyens 14 d'excitation électrique de N résonateurs couplés $16_1$, ..., $16_{i-1}$, $16_i$, $16_{i+1}$, ..., $16_N$ à l'aide de ce signal électrique d'entrée Ve.

Les moyens d'excitation électrique 14 comportent, pour chacun de ces N résonateurs couplés $16_1$, ..., $16_{i-1}$, $16_i$, $16_{i+1}$, ..., $16_N$, des moyens d'actionnement $18_1$, ..., $18_{i-1}$, $18_i$, $18_{i+1}$, ..., $18_N$ raccordés aux moyens 12 de fourniture du signal électrique d'entrée pour un actionnement de ce résonateur couplé en fonction du signal électrique d'entrée, et des moyens d'amplification d'entrée à gain variable $20_1$, ..., $20_{i-1}$, $20_i$, $20_{i+1}$, ..., $20_N$ respectifs. Chacun de ces moyens d'amplification d'entrée à gain variable $20_i$ est propre au résonateur couplé $16_i$ et est conçu pour amplifier l'actionnement de ce résonateur couplé.

En outre, les moyens d'excitation électrique 14 comportent des moyens 22 de commande d'un réglage spécifique du gain variable GEi de chacun des moyens d'amplification d'entrée $20_i$. Ces moyens de commande de gain sont classiques et ne seront donc pas détaillés. Ils sont de type programmable.

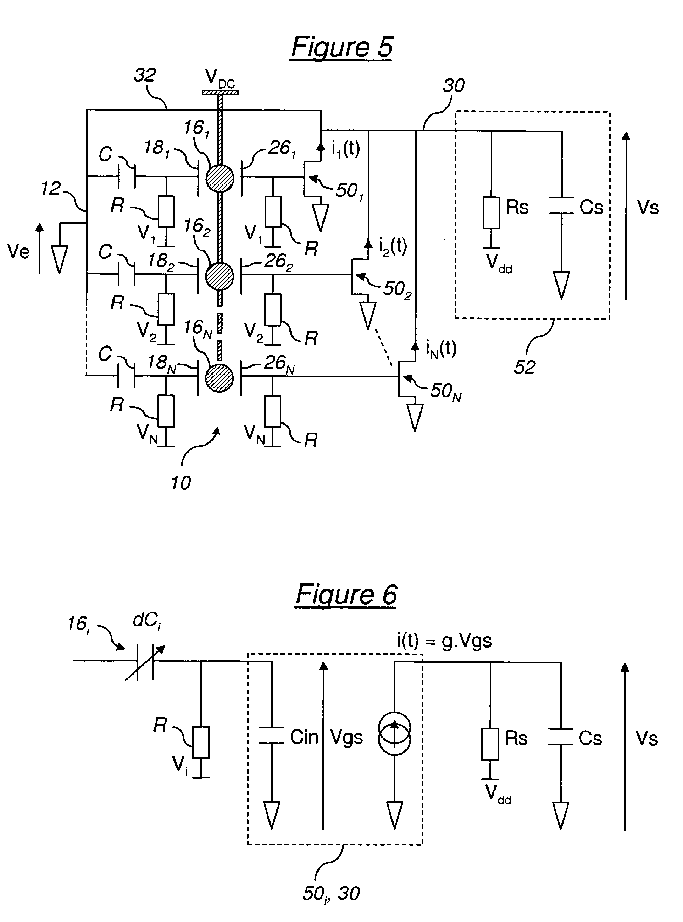

Comme illustré sur la figure 1, chacun des moyens d'amplification d'entrée $20_i$ est par exemple un amplificateur d'entrée à gain variable par l'intermédiaire duquel chacun des moyens d'actionnement correspondant $18_i$ est raccordé aux moyens 12 de fourniture du signal électrique d'entrée. Dans un autre mode de réalisation, par exemple celui qui sera détaillé en référence à la figure 5, les moyens d'amplification peuvent être intégrés aux moyens d'actionnement.

Ainsi, en agissant sur les différentes valeurs de gains GEi, l'actionnement est différemment pondéré pour exciter différemment les N résonateurs couplés $16_1$, ..., $16_{i-1}$, $16_i$, $16_{i+1}$, ..., $16_N$ du réseau 10. De cette façon, il est possible d'influer dynamiquement sur la fréquence centrale de résonance et sur la bande passante du réseau de résonateurs.

Chaque résonateur $16_i$ excité électriquement est par exemple un résonateur électromécanique comportant au moins un élément vibrant tel qu'un élément de type poutre vibrant en flexion, un élément de type disque, plaque ou poutre vibrant en volume ou au moins un nano fil.

Dans l'exemple particulier illustré sur la figure 1, fourni uniquement à titre illustratif et non limitatif, il s'agit, selon l'échelle, de résonateurs électromécaniques de type NEMS ou MEMS à disque vibrant. Les moyens d'actionnement électrostatique de chaque résonateur comportent alors une électrode d'excitation raccordée aux moyens 12 de fourniture du signal électrique d'entrée Ve par l'intermédiaire d'un amplificateur.

Dans cet exemple particulier également, le couplage des résonateurs du réseau 10 est mécanique et unidimensionnel dans le sens où les résonateurs sont couplés de proche en proche, de manière à former une ligne de N résonateurs couplés excités par N électrodes $18_1$, ..., $18_{i-1}$, $18_i$, $18_{i+1}$, ..., $18_N$. En d'autres termes, chaque résonateur $16_i$ est couplé mécaniquement à l'aide de structures mécaniques 24, d'une part au résonateur $16_{i-1}$, d'autre part au résonateur $16_{i+1}$, qui sont ses deux résonateurs adjacents dans le réseau 10. Les structures mécaniques de couplage 24 sont par exemple des nano/micro poutres, des ressorts, etc. Dans le cas d'un réseau de résonateurs électriques de type RLC, le couplage serait électrique et réalisé par un composant tel qu'une capacité ou une inductance mutuelle.

Aux extrémités du réseau 10, différentes conditions peuvent être envisagées, telles que celles fournissant un réseau de type encastré-encastré, encastré-libre, libre-libre, en cycle, etc. Parmi celles-ci, le résonateur $16_1$ peut être couplé mécaniquement à un résonateur $16_0$ fixe et non excité par une électrode. De même, le résonateur $16_N$ peut être couplé mécaniquement à un résonateur $16_{N+1}$ fixe et non excité par une électrode. Il s'agit alors de la configuration de réseau encastré-encastré.

Enfin, le nombre N peut varier de deux résonateurs jusqu'à des milliers de résonateurs, notamment dans le cas de résonateurs NEMS.

Le réseau 10 comporte en outre respectivement, pour chacun de ces N résonateurs couplés $16_1$, ..., $16_{i-1}$, $16_i$, $16_{i+1}$, ..., $16_N$, des moyens $26_1$, ..., $26_{i-1}$, $26_i$, $26_{i+1}$, ..., $26_N$ de détection d'une réaction de chaque résonateur couplé en réponse à l'excitation électrique des N résonateurs couplés $16_1$, ..., $16_{i-1}$, $16_i$, $16_{i+1}$, ..., $16_N$ par le signal électrique d'entrée Ve, et de transformation de cette réaction en un signal électrique intermédiaire. Dans l'exemple particulier illustré sur la figure 1, les moyens de détection et de transformation comportent des électrodes de détection capacitive. Chaque électrode $26_i$ est ainsi placée en face du résonateur $16_i$ correspondant pour détecter la variation de la capacité formée entre elle et ce résonateur suite aux vibrations mécaniques de ce dernier. Elle fournit en sortie le signal électrique intermédiaire précité.

Les électrodes de détection capacitive $26_1$, ..., $26_{i-1}$, $26_i$, $26_{i+1}$, ..., $26_N$ sont en outre toutes reliées en sortie à des moyens de regroupement des N signaux électriques intermédiaires pour former un signal électrique de sortie Vs. Les moyens de regroupement comportent par exemple un simple sommateur 30 auquel chaque électrode $26_i$ est reliée par l'intermédiaire d'un amplificateur de sortie $28_i$ à gain variable propre au résonateur couplé $16_i$.

Comme les amplificateurs d'entrée $20_1$, ..., $20_{i-1}$, $20_i$, $20_{i+1}$, ..., $20_N$, les amplificateurs de sortie $28_1$, ..., $28_{i-1}$, $28_i$, $28_{i+1}$, ..., $28_N$ peuvent être reliés aux moyens de commande 22 pour permettre un réglage spécifique de leurs gains GSi respectifs.

De même, dans un autre mode de réalisation, par exemple celui qui sera détaillé en référence à la figure 5, les amplificateurs de sortie peuvent être remplacés par des moyens d'amplification intégrés aux moyens de détection et de transformation. Une première utilisation possible de ce réseau de résonateurs 10 concerne le filtrage passe-bande d'un signal fourni en tant que signal électrique d'entrée Ve du réseau. En sortie, Vs représente alors le signal filtré.

Une seconde application possible de ce réseau de résonateurs 10 concerne la fourniture d'une base de temps par l'utilisation du réseau en tant qu'oscillateur. Pour ce faire, un circuit de rétroaction 32 relie la sortie du sommateur 30 à l'entrée du réseau, au niveau des moyens 12 de fourniture du signal électrique d'entrée et à la place du signal Ve, de manière à fournir le signal électrique d'entrée en fonction du signal électrique de sortie Vs du réseau de résonateurs 10 et à rendre ainsi le réseau résonant autour d'une fréquence propre.

La figure 2 représente un modèle mécanique équivalent du réseau de résonateurs couplés de la figure 1. En effet, le comportement dynamique des N résonateurs $16_1$, ..., $16_{i-1}$, $16_i$, $16_{i+1}$, ..., $16_N$, auxquels sont ajoutés les deux résonateur fixes d'extrémité $16_0$ et $16_{N+1}$, conçus et dimensionnés a priori pour être identiques et présenter ainsi une même fréquence de résonance, peut être assimilé à celui de résonateurs de type masse (m), ressort (de raideur $k_0$), amortissement (de facteur b) à un degré de liberté. Dans ce modèle, le couplage entre résonateurs adjacents est représenté par une raideur $k_c$.

Conformément à l'invention, à l'aide d'un même signal d'entrée Ve oscillant à une fréquence $\omega$, il est possible d'appliquer individuellement une excitation d'amplitude spécifique à chacun des N résonateurs $16_1$, ..., $16_{i-1}$, $16_i$, $16_{i+1}$, ..., $16_N$ en réglant les valeurs de gains GEi.

Dans le modèle mécanique de la figure 2, cela se traduit par une force vectorielle F d'actionnement oscillant à la fréquence $\omega$ dont chaque composante $f_i$ s'applique sur le résonateur $16_i$ indépendamment des autres. Il en résulte un déplacement mécanique oscillant à la fréquence $\omega$ et d'amplitude $u_i$ pour chacun des N résonateurs $16_1$, ..., $16_{i-1}$, $16_i$, $16_{i+1}$, ..., $16_N$. Ces N déplacements peuvent être définis comme un déplacement vectoriel U du réseau dont les composantes sont les déplacements de chacun des N résonateurs à un degré de liberté. Ils sont donnés par la relation

matricielle suivante :

$$\begin{bmatrix} -m\omega^2 + j\omega b + k_0 + 2k_c & -k_c & 0 & \cdots & 0 \\ -k_c & -m\omega^2 + j\omega b + k_0 + 2k_c & -k_c & & \vdots \\ 0 & -k_c & \ddots & \ddots & \\ \vdots & & \ddots & & -k_c \\ 0 & & \cdots & -k_c & -m\omega^2 + j\omega b + k_0 + 2k_c \end{bmatrix} \begin{bmatrix} u_1 \\ u_2 \\ \vdots \\ \vdots \\ u_N \end{bmatrix} = \begin{bmatrix} f_1 \\ f_2 \\ \vdots \\ \vdots \\ f_N \end{bmatrix}$$

$$(1)$$

On montre, par une approche modale, que la réponse vectorielle U des N résonateurs couplés peut s'exprimer comme une combinaison linéaire de N réponses vectorielles modales $U^n$, dits vecteurs modaux, dont les composantes $u_i^n$, correspondant respectivement aux déplacements modaux des résonateurs $16_i$, sont définies de la façon suivante :

$$u_i^n = \sin(\frac{i.n.\pi}{N+1}). \qquad (2)$$

On notera que les vecteurs modaux $U^n$ ainsi définis forment une base orthogonale pour le produit scalaire suivant :

$$\langle U^n | U^{n'} \rangle = \sum_{i=1}^{N} u_i^n u_i^{n'}. \qquad (3)$$

En effet, on vérifie que selon ce produit scalaire, $U^n | U^{n'} = 0 \Leftrightarrow n \neq n'$ et

$$\forall n, \langle U^n | U^n \rangle = \frac{N+1}{2}.$$

.

La composante de déplacement $u_i$ du résonateur $16_i$ peut donc s'écrire comme une combinaison linéaire des N composantes modales correspondant au résonateur $16_i$ :

$$u_i = \sum_{n=1}^{N} a_n u_i^n. \qquad (5)$$

On montre également que chaque vecteur modal correspond à un mode de réponse du réseau ayant son propre gain, sa propre bande passante et sa propre fréquence (ou pulsation) de résonance. En projetant l'équation matricielle définie précédemment sur la base constituée de ces vecteurs modaux, il est aisé de retrouver les fonctions de transfert $G_n(\omega)$ et les pulsations de résonance $\omega_n$ correspondant à chaque mode :

$$G_n(\omega) = \frac{a_n}{f_n}(\omega) = \frac{1/m}{-\omega^2 + j\omega b/m + \omega_n^2}, \text{ et} \qquad (6)$$

$$\omega_n^2 = \frac{k_0 + 2k_c(1-\cos(\frac{n\pi}{N+1}))}{m}. \qquad (7)$$

Ainsi, on observe que pour un réseau unidimensionnel de N résonateurs couplés $16_1$, ..., $16_{i-1}$, $16_i$, $16_{i+1}$, ..., $16_N$ à un degré de liberté, auxquels sont ajoutés, aux deux extrémités, deux résonateurs fixes couplés respectivement aux résonateurs $16_1$ et $16_N$, il y a N fréquences de résonances distinctes dans l'intervalle

$$\left[\frac{k_0}{m}, \frac{k_0 + 4k_c}{m}\right]. \qquad (8)$$

Selon le modèle représenté sur la figure 2, on active l'un uniquement des N modes de réponse du réseau 10 en projetant l'actionnement du réseau de résonateurs sur le vecteur modal correspondant. En d'autres termes, en appliquant une force vectorielle F distribuée de telle sorte qu'elle soit colinéaire à l'un des vecteurs modaux $U^n$, on obtient une réponse fréquentielle du réseau conforme au mode n correspondant, dont le gain et la fréquence (ou pulsation) de résonance sont donnés par les équations (6) et (7).

Par analogie, dans un mode de réalisation de l'invention, on active l'un des N modes de réponse fréquentielle du réseau 10 en projetant le signal d'entrée Ve sur l'un des N vecteurs modaux du réseau 10, c'est-à-dire en réglant sélectivement la valeur des N gains variables GEi des amplificateurs $20_1$, ..., $20_{i-1}$, $20_i$, $20_{i+1}$, ..., $20_N$ en fonction des composantes de l'un des N vecteurs modaux, plus précisément proportionnellement à ces composantes. Cette projection force le réseau 10 à réagir comme un filtre passe-bande sur le mode sélectionné. Par conséquent, seul le mode correspondant au vecteur modal sur lequel est projeté le signal d'entrée Ve est activé, les autres modes ne répondant pas, étant donné que leurs coefficients modaux sont nuls pour n'importe quelle fréquence d'excitation. Le réglage sélectif des gains GEi est réalisé par les moyens de commande 22.

Plus généralement, selon l'invention, on ajuste la fréquence centrale et la bande passante du filtrage réalisé par le réseau de résonateurs 10 en choisissant un ou plusieurs modes à activer grâce au réglage des gains variables GEi.

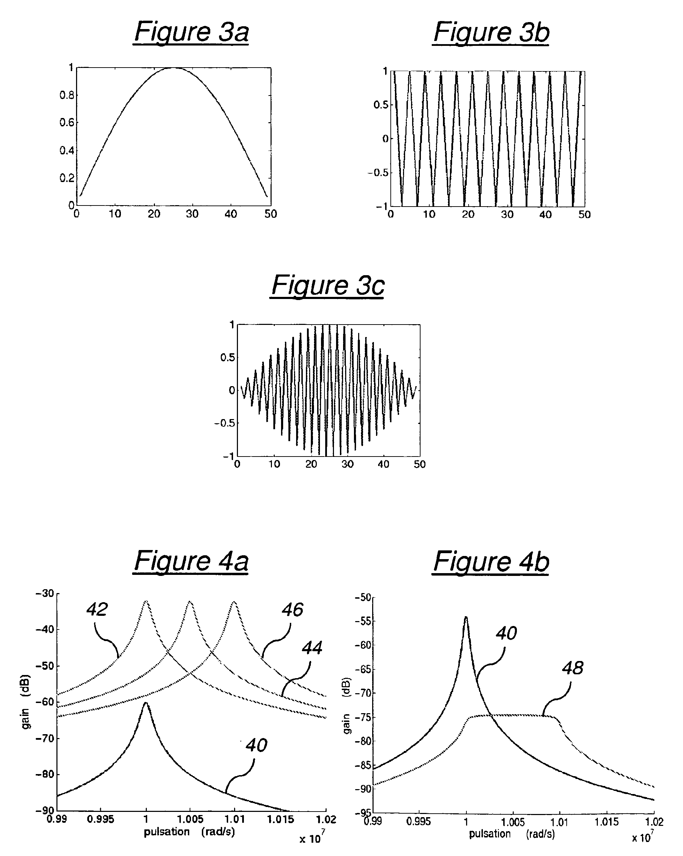

Les figures 3a à 3c illustrent graphiquement des exemples de vecteurs modaux pour un réseau aux extrémités fixes de N=49 résonateurs couplés de type NEMS de pulsation de résonance égale à $10^7$ *rad/s*. La figure 3a représente les quarante-neuf composantes du vecteur modal du premier mode (n=1), la figure 3b les quarante-neuf composantes du vecteur modal du mode central (n=25) et la figure 3c les quarante-neuf composantes du vecteur modal du dernier mode (n=49).

Les composantes de ces vecteurs modaux représentent également les quarante-neuf valeurs de gains GEi à régler par les moyens de commande 22 pour forcer le réseau 10 à réagir dans le mode correspondant par projection de l'actionnement Ve sur le vecteur modal souhaité.

Lorsqu'un mode particulier est sélectionné par réglage des gains d'entrée GEi en fonction des composantes du vecteur modal correspondant, le signal de sortie Vs du réseau de résonateurs peut être obtenu en sortie d'un seul résonateur du réseau. Avantageusement, il est préférable de regrouper les sorties de tous les résonateurs du réseau 10 à l'aide du sommateur 30 pour tirer profit de l'ensemble des réponses, de manière à élever l'amplitude du signal de sortie Vs et réduire l'impédance du réseau de résonateurs.

Mais si ce regroupement est réalisé directement par connexion des électrodes de détection $26_1$, ..., $26_{i-1}$, $26_i$, $26_{i+1}$, ..., $26_N$ au sommateur 30, on obtient :

$$Vs = \sum_{i=1}^{N} u_i = \sum_{i=1}^{N} a_n u_i^n = a_n \sum_{i=1}^{N} \sin(\frac{i.n.\pi}{N+1}) = \begin{cases} 0 & \text{pour } n \text{ pair} \\ \dfrac{2(N+1)}{n.\pi} & \text{pour } n \text{ impair} \end{cases}. \qquad (9)$$

Un tel regroupement n'est pas exploitable parce que le signal de sortie Vs est nul pour les modes pairs et décroissant en fonction de n pour les modes impairs.

Selon un mode de réalisation de l'invention, les électrodes de détection $26_1$, ..., $26_{i-1}$, $26_i$, $26_{i+1}$, ..., $26_N$ sont reliées au sommateur 30 par l'intermédiaire des amplificateurs de sortie $28_1$, ..., $28_{i-1}$, $28_i$, $28_{i+1}$, ..., $28_N$ dont les gains GSi sont variables. Les moyens de commande 22 sont alors conçus pour régler la valeur des gains variables GSi en fonction de celle des gains GEi, c'est-à-dire en fonction des composantes du vecteur modal sélectionné en entrée du réseau de résonateurs. Plus précisément, le gain GSi de l'amplificateur de sortie $28_i$ du résonateur $16_i$ est choisi égal au gain GEi de l'amplificateur d'entrée $20_i$ de ce même résonateur.

En utilisant la propriété d'orthogonalité (équation 4) du produit scalaire défini précédemment, on obtient alors en sortie :

$$Vs = \sum_{i=1}^{N} u_i u_i^n = \sum_{i=1}^{N} a_n u_i^n u_i^n = a_n \sum_{i=1}^{N} u_i^n u_i^n = a_n \langle U^n | U^n \rangle = \frac{N+1}{2} a_n . \qquad (10)$$

Ainsi, on observe que ce réglage particulier des gains des amplificateurs de sortie permet d'amplifier le gain global en sortie du réseau de résonateurs d'un facteur (N+1)/2 par rapport au gain d'un seul résonateur. Ce réglage améliore le rapport signal sur bruit du réseau de résonateurs par rapport à un seul résonateur et le rend plus sensible en détection.

La figure 4a illustre graphiquement des exemples 42, 44 et 46 de modes de fonctionnement possibles pour un réseau 10 aux extrémités fixes de N=49 résonateurs couplés de type NEMS de pulsation de résonance égale à $10^7$ *rad/s*. A titre de comparaison, la réponse fréquentielle d'un seul de ces résonateurs, dans le cas où il n'est pas couplé à un autre, est représentée par la courbe 40, centrée autour de la pulsation de résonance $10^7$ *rad/s*.

La courbe 42 représente la réponse fréquentielle du réseau 10 selon son premier mode de fonctionnement, lorsque les gains GEi et GSi sont fixés par les moyens de commande 22 aux valeurs des composantes du vecteur modal représenté sur la figure 3a. La valeur de la fréquence centrale de cette réponse fréquentielle est donnée par une relation équivalente à celle de l'équation (7) pour n=1.

La courbe 44 représente la réponse fréquentielle du réseau 10 selon son mode central de fonctionnement, lorsque les gains GEi et GSi sont fixés par les moyens de commande 22 aux valeurs des composantes du vecteur modal représenté sur la figure 3b. La valeur de la fréquence centrale de cette réponse fréquentielle est donnée par une relation équivalente à celle de l'équation (7) pour n=25.

Enfin, la courbe 46 représente la réponse fréquentielle du réseau 10 selon son dernier mode de fonctionnement, lorsque les gains GEi et GSi sont fixés par les moyens de commande 22 aux valeurs des composantes du vecteur modal représenté sur la figure 3c. La valeur de la fréquence centrale de cette réponse fréquentielle est donnée par une relation équivalente à celle de l'équation (7) pour n=49.

On remarque que le gain global du réseau de résonateur 10 dans chacun de ses modes de fonctionnement est largement supérieur à celui d'un seul résonateur, comme prévu par l'équation (10).

Selon un autre fonctionnement possible du réseau de résonateurs 10 illustré sur la figure 4b, lorsque seul le premier résonateur $16_1$ est excité par le signal d'entrée Ve, tous les modes de fonctionnement du réseau sont activés via le couplage entre tous les résonateurs. Ces modes sont activés à l'aide d'une fonction sinusoïdale de modulation

$$f_n = \sin(\frac{n.\pi}{N+1}) ,$$

, ce qui permet d'obtenir un filtrage à large bande passante couvrant tout l'intervalle (8) des fréquences centrales des N modes de fonctionnement précités. Un tel filtrage à large bande est illustré par la courbe 48.

Il apparaît donc clairement que le réseau de résonateurs 10 permet de réaliser un filtre ou un oscillateur à fréquence centrale et à bande passante ajustables en prévoyant des moyens de réglage favorisant simplement et précisément un ou plusieurs ou tous ses modes de fonctionnement.

On peut d'ailleurs augmenter le nombre de modes de fonctionnement du réseau en augmentant le nombre N de ses résonateurs couplés à au moins un degré de liberté. Cela permet ainsi d'augmenter la finesse de l'ajustement possible de la fréquence centrale de ce réseau de résonateurs dans l'intervalle (8) précité.

On peut aussi élargir cet intervalle en augmentant la force du couplage entre les résonateurs (facteur $k_c$). Plus le couplage est fort, plus l'intervalle entre la fréquence centrale du premier mode et celle du dernier mode est grand, de même que l'intervalle entre fréquences centrales de modes adjacents.

Enfin, lorsque l'on réalise concrètement un tel réseau de N résonateurs couplés, surtout lorsque les résonateurs sont de petite taille tels que des résonateurs NEMS ou MEMS, une dispersion des paramètres caractéristiques de ces résonateurs (fréquence de résonance propre et facteur de qualité) peut avoir un effet négatif sur les performances du réseau. On montre en fait qu'en jouant sur la valeur du couplage entre résonateurs, mais surtout qu'en augmentant le nombre de résonateurs couplés, on réduit sensiblement l'effet de cette dispersion sur le réseau. En fait, plus précisément, l'écart-type des fréquences de résonance propres des N résonateurs $16_1$, ..., $16_{i-1}$, $16_i$, $16_{i+1}$, ..., $16_N$ est inversement proportionnel à la racine carrée ce de nombre N. Ainsi, augmenter N permet non seulement d'améliorer la finesse de l'ajustement possible de la fréquence centrale du réseau de résonateurs, mais aussi de compenser une dispersion des paramètres caractéristiques des résonateurs.

Comme indiqué précédemment, le réseau de résonateurs 10 décrit ci-dessus peut être utilisé comme filtre passe-bande à fréquence centrale et bande passante ajustables. Dans cette application, le signal d'entrée du filtre est le signal Ve et Vs est le signal filtré.

Le réseau de résonateurs 10 peut aussi être utilisé comme élément d'un oscillateur à fréquence centrale ajustable. Dans cette application, il doit être associé à un circuit de rétroaction apte à renvoyer le signal de sortie en entrée du réseau de résonateur tout en assurant un certain déphasage pour remplir les conditions de réaction nécessaires pour la mise en oscillation du réseau. Un exemple de réalisation d'oscillateur intégrant un réseau de résonateurs selon un mode de réalisation de l'invention va maintenant être détaillé en référence à la figure 5.

L'oscillateur représenté sur la figure 5 comporte un réseau de résonateurs de type NEMS ou MEMS, par exemple identique au réseau précédemment décrit. Il porte alors la même référence 10. Selon cette structure, les résonateurs sont excités par actionnement électrostatique, à l'aide d'électrodes, et leurs déplacements sont mesurés par une détection capacitive, à l'aide d'électrodes également. En effet, du point de vue de l'excitation, chaque résonateur $16_i$ est soumis à une différence de potentiel alternative entre sa structure métallique et l'électrode d'excitation $18_i$ correspondante, ce qui génère une force électrostatique oscillatoire provoquant une vibration du résonateur. Du point de vue de la détection, chaque vibration du résonateur $16_i$ génère une variation de capacité entre sa structure métallique et l'électrode de détection $26_i$ correspondante.

L'entrée 12 du réseau de résonateurs est soumise à une tension sinusoïdale Ve modulée pour chaque résonateur $16_i$ par l'électrode d'excitation $18_i$ dont le gain de transduction est variable et proportionnel à sa tension de polarisation $V_i$. La valeur de cette tension de polarisation $V_i$ est réglable par les moyens de commande 22 et propre à chaque résonateur $16_i$. En effet, du point de vue de l'actionnement électrostatique, si en outre chaque résonateur $16_i$ est relié à un potentiel commun $V_{DC}$, la différence de potentiel entre sa structure métallique et son électrode d'excitation est égale à $(V_i - V_{DC}) + Ve$. En considérant les déplacements de faible amplitude, la force électrostatique s'exerçant sur le résonateur $16_i$ prend la forme suivante :

$$f = \frac{\varepsilon_0 . S . \left[(V_i - V_{DC}) + Ve\right]^2}{d^2} \approx f_0 + \frac{\varepsilon_0 . S . (V_i - V_{DC}) . Ve}{d^2} , \qquad (11)$$

où $f_0$ est une composante continue, S est la surface de l'électrode d'excitation $18_i$ et d est la distance entre l'électrode d'excitation $18_i$ et le résonateur $16_i$.

On voit bien d'après cette équation (11) qu'une amplification à gain variable $(V_i - V_{DC})$ est réalisée sur la tension Ve par commande externe de la valeur de la tension $V_i$. On peut donc régler chaque valeur de $V_i$ pour que chaque valeur $(V_i - V_{DC})$ reproduise la valeur de la composante correspondante de l'un des vecteurs modaux du réseau de résonateur 10, de manière à régler ce dernier sur l'un de ses modes de résonance.

De façon pratique, des résistances R sont utilisées pour la polarisation des électrodes d'excitation $18_1$, ..., $18_i$, ..., $18_N$ qui sont en outre reliées aux moyens 12 de fourniture du signal d'entrée par l'intermédiaire de capacités C.

Du point de vue de la détection, la réaction de chaque résonateur $16_i$ est détectée et modulée par l'électrode de détection $26_i$ dont le gain de transduction est variable et proportionnel à sa tension de polarisation $V_i$. Cette tension de polarisation $V_i$ est réglée par les moyens de commande 22 pour être égale à la tension de polarisation de l'électrode d'excitation $18_i$ de manière à amplifier la sortie du réseau de résonateurs comme indiqué précédemment. En outre, le signal intermédiaire fourni par l'électrode de détection $26_i$ traverse un étage de gain $50_i$ comprenant un transistor de transconductance g pour la fourniture d'un courant d'intensité $i_i(t)$ porteur du signal de sortie.

Le sommateur 30 est alors réalisé par un simple regroupement des étages de gain $50_i$. Il fournit un courant

$$i(t) = \sum_{k=1}^{N} i_i(t) . \quad .$$

L'oscillateur représenté sur la figure 5 comporte en outre un circuit de lecture 52. Ce circuit de lecture comporte une résistance de charge Rs reliée à un potentiel prédéterminé Vdd et une capacité de charge Cs reliée à la masse aux bornes de laquelle est mesurée la tension de sortie Vs.

Ainsi, du point de vue de la détection, chaque résonateur $16_i$ pouvant être considéré comme un condensateur à capacité variable $dC_i$ oscillant à une fréquence égale à celle du signal d'entrée Ve et différemment polarisée, le circuit reliant ce résonateur $16_i$ et son électrode de détection $26_i$ à la capacité de charge Cs et constitué de l'étage de gain $50_i$, du sommateur 30 et du circuit de lecture 52 peut être modélisé par un circuit équivalent représenté sur la figure 6.

Selon le circuit équivalent, le transistor $50_i$ de l'étage de gain et le sommateur 30 sont représentés par un premier circuit de charge capacitive d'entrée Cin reliée à la masse fournissant une tension Vgs et un second circuit générateur de courant sur la base de la tension Vgs et de la transconductance g du transistor $50_i$. On montre que, pour chaque transistor $50_i$, la fonction de transfert H reliant la tension de sortie Vs à la capacité variable $dC_i$ représentant les déplacements du résonateur $16_i$ prend la forme suivante :

$$H = \frac{Vs}{dC_i} = -\frac{g(V_i - V_{DC})}{C_{in}\, Cs\, j\omega}\,. \tag{12}$$

Par conséquent, les conditions classiques de Barkhausen nécessaires pour la mise en oscillation de l'oscillateur sont vérifiées puisque la fonction de transfert H montre que la tension de sortie est proportionnelle à la capacité variable $dC_i$ du résonateur $16_i$ pondérée par le gain ($V_i$-$V_{DC}$) et qu'en outre elle subit une intégration (1/j$\omega$).

En connectant tous les résonateurs au circuit de charge 52 et en reliant ce circuit de charge commun à l'entrée 12 à l'aide du circuit de rétroaction 32, de sorte que Ve = Vs, l'ensemble illustré sur la figure 5 remplit la fonction d'un oscillateur à fréquence de résonance ajustable entre plusieurs modes de fonctionnement. Dans cette configuration, la présence des capacités C entre les électrodes d'excitation $18_1$, ..., $18_i$, ..., $18_N$ et les moyens 12 de fourniture du signal d'entrée permet de découpler les tensions de polarisation des électrodes d'excitation de la tension continue en sortie des transistors $50_1$, ..., $50_i$, ..., $50_N$. En supprimant le circuit de rétroaction 32, l'ensemble remplit simplement la fonction d'un filtre à fréquence centrale ajustable.

On notera que l'étage de gain précité peut être réalisé en technologie CMOS, bipolaire ou bien encore en technologie bi-CMOS. Dans l'exemple des figures 5 et 6, il est assimilé à un modèle petit signal de transistor MOS à effet de champ. Mais il pourrait tout aussi bien être assimilé à un modèle petit signal de transistor bipolaire en remplaçant les capacités par des résistances, le principe des calculs restant identique.

Dans le mode de réalisation décrit précédemment en référence aux figures 1 à 6, dans lequel le couplage des résonateurs est unidimensionnel, on ajuste la fréquence centrale du réseau de résonateurs en sélectionnant un mode en particulier grâce au choix d'une pondération des gains d'entrée et de sortie conforme aux composantes d'un vecteur modal parmi N vecteurs modaux prédéfinis. Cependant, la bande passante du réseau de résonateurs dans le mode de fonctionnement sélectionné est étroite au vu des courbes 42 à 46. Dans ce mode de réalisation, pour obtenir simplement une bande passante plus large, telle que celle de la courbe 48, il faut par exemple activer tous les modes et dans ce cas la fréquence centrale n'est pas ajustable.

Pour obtenir une large bande passante telle que celle illustrée par la courbe 48 tout en ayant la possibilité de régler la fréquence centrale, une solution est donnée par le mode de réalisation illustré sur la figure 7.

Dans ce second mode de réalisation, le couplage des résonateurs du réseau 10 est bidimensionnel dans le sens où les résonateurs sont, d'une part, couplés de proche en proche par des premiers moyens de couplage $24_1$ de manière à former des lignes i de N résonateurs couplés $16_{i,1}$, ..., $16_{i,j}$, ..., $16_{i,N}$ excités par N moyens d'actionnement $18_{i,1}$, ..., $18_{i,j}$, ..., $18_{i,N}$, et, d'autre part, couplés de proche en proche par des seconds moyens de couplage $24_2$ de manière à former des colonnes j de M résonateurs couplés $16_{1,j}$, ..., $16_{i,j}$, ..., $16_{M,j}$ excités par M moyens d'actionnement $18_{1,j}$, ..., $18_{i,j}$, ..., $18_{M,j}$.

Le couplage $24_1$ entre résonateurs d'une même ligne i est par exemple faible, de manière à générer des modes (qu'on qualifiera d'horizontaux) de fréquences centrales proches, et celui ($24_2$) entre résonateurs d'une même colonne j est par exemple fort, de manière à générer des modes (qu'on qualifiera de verticaux) de fréquences centrales éloignées.

Le réseau de résonateur 10 résultant comporte donc une matrice de MxN résonateurs $16_{i,j}$ couplés en M lignes et N colonnes.

Dans l'exemple particulier illustré sur la figure 7, fourni uniquement à titre illustratif et non limitatif, ces résonateurs sont, selon l'échelle, des résonateurs électromécaniques de type NEMS ou MEMS à disque vibrant. Les moyens d'actionnement $18_{i,j}$ de chaque résonateur $16_{i,j}$ comportent alors une électrode d'excitation électrostatique dont on peut régler le gain de transduction GEi,j en réglant sa tension de polarisation à l'aide des moyens de commande 22 (non représentés sur cette figure). En variante, l'électrode d'excitation électrostatique des moyens d'actionnement $18_{i,j}$ peut avoir la même polarisation que les autres et être raccordée aux moyens de fourniture 12 du signal électrique d'entrée par l'intermédiaire d'un amplificateur d'entrée à gain variable GEi,j (non représenté sur cette figure). En outre, les moyens de détection $26_{i,j}$ de chaque résonateur $16_{i,j}$ comportent une électrode de détection capacitive pour détecter la réaction du résonateur $16_{i,j}$ par la mesure d'un paramètre électrique variable (i.e. la capacité entre le résonateur et l'électrode) du fait de ses vibrations.

Chaque électrode de détection $26_{i,j}$ est reliée en sortie au sommateur 30 pour former un signal électrique de sortie Vs. Son gain de transduction peut par exemple être réglable par réglage de sa tension de polarisation à l'aide des moyens de commande 22 (non représentés sur cette figure). En variante, l'électrode de détection $26_{i,j}$ peut avoir la même polarisation que les autres et être reliée au sommateur 30 par l'intermédiaire d'un amplificateur de sortie à gain variable $28_{i,j}$ (non représenté sur cette figure) propre au résonateur couplé $16_{i,j}$. Dans cette configuration, comme les amplificateurs d'entrée $20_{i,j}$, les amplificateurs de sortie $28_{i,j}$ peuvent être reliés aux moyens de commande 22 pour permettre un réglage spécifique de leurs gains GSi,j respectifs.

Dans cet exemple particulier également, le couplage bidimensionnel des résonateurs du réseau 10 est mécanique. En d'autres termes, chaque résonateur $16_{i,j}$ est couplé mécaniquement à l'aide de structures mécaniques formant les moyens de couplage $24_1$, d'une part au résonateur $16_{i,j-1}$, d'autre part au résonateur $16_{i,j+1}$, qui sont ses deux résonateurs adjacents dans la ligne i ; chaque résonateur $16_{i,j}$ est également couplé mécaniquement à l'aide de structures mécaniques formant les moyens de couplage $24_2$, d'une part au résonateur $16_{i-1,j}$, d'autre part au résonateur $16_{i+1,j}$, qui sont ses deux résonateurs adjacents dans la colonne j. Les structures mécaniques de couplage $24_1$ et $24_2$ sont par exemple des nano/micro poutres, des ressorts, etc. Dans le cas d'un réseau de résonateurs électriques de type RLC, le couplage serait électrique et réalisé par un composant tel qu'une capacité ou une inductance mutuelle.

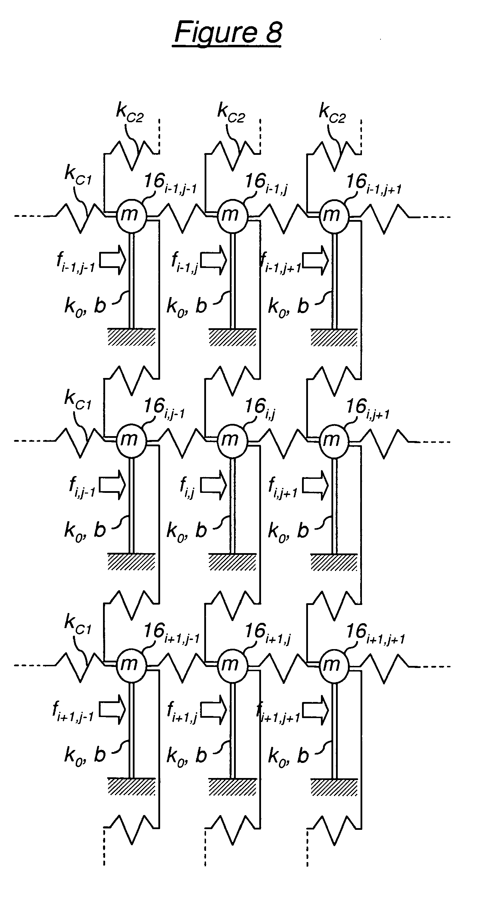

La figure 8 représente un modèle mécanique équivalent du réseau de résonateurs couplés de la figure 7. Dans ce modèle, les résonateurs sont de type masse ($\mu$), ressort (de raideur $k_0$), amortissement (de facteur b) à deux degrés de liberté. Le couplage entre résonateurs adjacents d'une même ligne est représenté par une raideur $k_{C1}$ et le couplage entre résonateurs adjacents d'une même colonne est représenté par une raideur $k_{C2}$.

Conformément à l'invention, à l'aide d'un même signal d'entrée Ve oscillant à une fréquence $\omega$, il est possible d'appliquer individuellement une excitation d'amplitude spécifique à chacun des M.N résonateurs $16_{1,1}$, ..., $16_{i,j}$, ..., $16_{M,N}$ en réglant les valeurs de gains GEi,j.
Dans le modèle mécanique de la figure 8, cela se traduit par une force matricielle F d'actionnement oscillant à la fréquence $\omega$ dont chaque composante $f_{i,j}$ s'applique sur le résonateur $16_{i,j}$ indépendamment des autres. Il en résulte un déplacement mécanique oscillant à la fréquence $\omega$ et d'amplitude $u_{i,j}$ pour chacun des M.N résonateurs $16_{1,1}$, ..., $16_{i,j}$, ..., $16_{M,N}$. Ces M.N déplacements peuvent être définis comme un déplacement matriciel U du réseau dont les composantes sont les déplacements de chacun des M.N résonateurs.

On montre, par une approche modale et comme dans la situation d'un réseau unidimensionnel, que la réponse matricielle U des M.N résonateurs couplés peut s'exprimer comme une combinaison linéaire de M.N réponses matricielles modales $U^{m,n}$, dites vecteurs modaux, dont les composantes $u_{i,j}^{m,n}$, , correspondant respectivement aux déplacements modaux des résonateurs $16_{i,j}$, sont définies de la façon suivante, sous certaines conditions de fixation aux extrémités :

$$u_{i,j}^{m,n} = \sin(\frac{i.m.\pi}{M+1}).\sin(\frac{j.n.\pi}{N+1}) . \tag{13}$$

On notera que les vecteurs modaux $U^{m,n}$ ainsi définis forment une base orthogonale pour le produit scalaire suivant :

$$\left\langle U^{m,n} \middle| U^{m',n'} \right\rangle = \sum_{i=1}^{M} \sum_{j=1}^{N} u_{i,j}^{m,n} . u_{i,j}^{m',n'} . \tag{14}$$

En effet, on vérifie que selon ce produit scalaire,

$$\left\langle U^{m,n} \middle| U^{m',n'} \right\rangle = 0 \Leftrightarrow (m,n) \neq (m',n') \text{ et } \forall (m,n), \left\langle U^{m,n} \middle| U^{m,n} \right\rangle = \frac{M+1}{2} . \frac{N+1}{2} . \tag{15}$$

La composante de déplacement $u_{i,j}$ du résonateur $16_{i,j}$ peut donc s'écrire comme une combinaison linéaire des M.N composantes modales correspondant au résonateur $16_{i,j}$ :

$$u_{i,j} = \sum_{m=1}^{M} \sum_{n=1}^{N} a_{m,n} . u_{i,j}^{m,n} . \tag{16}$$

On montre également que chaque vecteur modal correspond à un mode de réponse du réseau ayant son propre gain, sa propre bande passante et sa propre fréquence (ou pulsation) de résonance. En projetant l'équation matricielle définie précédemment sur la base constituée de ces vecteurs modaux, il est aisé de retrouver les fonctions de transfert $G_{m,n}(\omega)$ et les pulsations de résonance $\omega_{m,n}$ correspondant à chaque mode :

$$G_{m,n}(\omega) = \frac{a_{m,n}}{f_{m,n}}(\omega) = \frac{1/\mu}{-\omega^2 + j\omega b/\mu + \omega_{m,n}^2} \text{, et} \qquad (17)$$

$$\omega_{m,n}^2 = \frac{k_0 + 2k_{C2}(1-\cos(\frac{m\pi}{M+1})) + 2k_{C1}(1-\cos(\frac{n\pi}{N+1}))}{\mu}. \qquad (18)$$

Ainsi, on observe que pour un réseau bidimensionnel de M.N résonateurs couplés $16_{1,1}$, ..., $16_{i,j}$, ..., $16_{M,N}$ à deux degrés de liberté, auxquels sont ajoutés, aux deux extrémités, des résonateurs fixes, il y a M.N fréquences de résonances distinctes dans l'intervalle

$$\left[\frac{k_0}{\mu}, \frac{k_0 + 4k_{C1} + 4k_{C2}}{\mu}\right]. \qquad (19)$$

Selon le modèle représenté sur la figure 8, on peut activer l'un uniquement des M.N modes de réponse du réseau 10 en projetant l'actionnement du réseau de résonateurs sur le vecteur modal correspondant. En d'autres termes, en appliquant une force vectorielle F distribuée de telle sorte qu'elle soit colinéaire à l'un des vecteurs modaux $U^{m,n}$, on obtient une réponse fréquentielle du réseau conforme au mode (m,n) correspondant, dont le gain et la fréquence (ou pulsation) de résonance sont donnés par les équations (17) et (18).

Par analogie, dans un mode de réalisation de l'invention, on peut activer l'un des M.N modes de réponse fréquentielle du réseau 10 en projetant le signal d'entrée Ve sur l'un des M.N vecteurs modaux du réseau 10, c'est-à-dire en fixant sélectivement la valeur des M.N gains variables GEi,j des amplificateurs $20_{1,1}$, ..., $20_{i,j}$, ..., $20_{M,N}$ en fonction des composantes de l'un des M.N vecteurs modaux, plus précisément proportionnellement à ces composantes. Cette projection force le réseau 10 à réagir comme un filtre passe-bande sur le mode sélectionné. Par conséquent, seul le mode correspondant au vecteur modal sur lequel est projeté le signal d'entrée Ve est activé, les autres modes ne répondant pas, étant donné que leurs coefficients modaux sont nuls pour n'importe quelle fréquence d'excitation. Le réglage sélectif des gains GEi,j est réalisé par les moyens de commande 22.

Selon un autre fonctionnement possible du réseau de résonateurs 10 illustré sur la figure 9, lorsque seul le premier résonateur $16_{i,1}$ de chaque ligne i est excité par le signal d'entrée Ve, tous les modes de fonctionnement (i,n) de cette ligne i sont activés via le couplage $k_{C1}$ entre tous les résonateurs de la ligne. Ces modes sont activés à l'aide d'une fonction sinusoïdale de modulation $f_{m,n}(i) = \sin(\frac{i.m\pi}{M+1}).\sin(\frac{n\pi}{N+1})$, , ce qui permet d'obtenir un filtrage à large bande passante couvrant tout l'intervalle des fréquences centrales des N modes de fonctionnement de la ligne i, dans l'un des M modes de fonctionnement verticaux possibles.

La figure 9 illustre ainsi graphiquement des exemples 54, 56 et 58 de modes de fonctionnement possibles pour un réseau 10 aux extrémités fixes de M=3 par N=30 résonateurs couplés de type NEMS de pulsation de résonance égale à $10^7$ rad/s. A titre de comparaison, la réponse fréquentielle d'un seul de ces résonateurs serait représentée par la courbe 40 s'il n'était pas couplé à d'autres, cette courbe étant centrée autour de la pulsation de résonance $10^7$ rad/s.

La courbe 54 représente la réponse fréquentielle du réseau 10 selon son premier mode de fonctionnement vertical (m=1), lorsque les gains GEi,1 et GSi,1 sont fixés par les moyens de commande 22 aux valeurs de la fonction $f_{1,n}(i)$.

La courbe 56 représente la réponse fréquentielle du réseau 10 selon son deuxième mode de fonctionnement vertical (m=2), lorsque les gains GEi,2 et GSi,2 sont fixés par les moyens de commande 22 aux valeurs de la fonction $f_{2,n}(i)$.

Enfin, la courbe 58 représente la réponse fréquentielle du réseau 10 selon son dernier mode de fonctionnement vertical (m=3), lorsque les gains GEi,3 et GSi,3 sont fixés par les moyens de commande 22 aux valeurs de la fonction $f_{3,n}(i)$.

Grâce à ce réseau bidimensionnel, on voit qu'il est possible d'obtenir soit un réseau de résonateurs à filtrage large bande et à fréquence centrale ajustable selon M modes verticaux différents soit un réseau de résonateurs à bande étroite et à fréquence centrale ajustable selon M.N modes différents.

Il apparaît clairement qu'un réseau de résonateurs tel que l'un de ceux décrits précédemment permet d'ajuster avec une bonne précision la fréquence centrale de résonance par un simple réglage de gains.

En outre, en projetant l'actionnement mais aussi la détection sur un même mode de fonctionnement, on peut augmenter sensiblement l'amplitude du signal de sortie du réseau de résonateurs puisque celle-ci est alors proportionnelle au nombre de résonateurs.

Ainsi, dans une utilisation du réseau en tant qu'oscillateur, il n'est pas nécessaire de prévoir un gain élevé dans l'électronique de réaction pour entretenir les oscillations, puisque le signal de sortie est déjà très amplifié dans le cas d'un nombre important de résonateurs utilisés dans le réseau.

Dans des applications de type filtrage sélectif, il est possible d'envisager des capteurs résonants à base de réseaux tels que ceux décrits précédemment pour concevoir des capteurs de masse, d'accélération, de pression ou autre. Le même principe utilisé dans les capteurs à un seul résonateur peut être appliqué, mais en ayant un signal de mesure plus important d'un facteur proportionnel au nombre de résonateurs, améliorant ainsi le rapport signal sur bruit et facilitant par suite la détection de très faibles variations.

Par ailleurs, si les bruits inhérents à chaque résonateur ne sont pas corrélés, on montre que le bruit de phase généré dans le réseau de résonateurs est réduit du fait qu'il est inversement proportionnel à la racine carrée du nombre de résonateurs.

De même, le réseau de résonateurs est robuste face à la dispersion des fréquences de résonance des résonateurs puisque l'écart type de cette dispersion est lui aussi inversement proportionnel à la racine carrée du nombre de résonateurs.

Enfin, dans le cas de résonateurs de très petite taille tels que les résonateurs de type NEMS, le réseau de résonateurs peut rester de très petite taille lui aussi, notamment de taille inférieure aux résonateurs de type MEMS connus. Il peut en outre être réalisé par une technique de co-intégration permettant la réalisation simultanée des résonateurs et des composants électriques.

On notera par ailleurs que l'invention n'est pas limitée aux modes de réalisation décrits précédemment. Diverses modifications peuvent être apportées par l'homme de l'art aux modes de réalisation décrits ci-dessus, à la lumière de l'enseignement qui vient de lui être divulgué. Dans les revendications qui suivent, les termes utilisés ne doivent pas être interprétés comme limitant les revendications aux modes de réalisations exposés dans la présente description, mais doivent être interprétés pour y inclure tous les équivalents que les revendications visent à couvrir du fait de leur formulation et dont la prévision est à la portée de l'homme de l'art en appliquant ses connaissances générales à la mise en oeuvre de l'enseignement qui vient de lui être divulgué.

Notamment, les résonateurs ne sont pas nécessairement réalisés en technologie NEMS/MEMS. Ils peuvent aussi être réalisés à base de résonateurs quartz, électromécaniques autres que NEMS/MEMS ou par des circuits de composants électriques passifs RLC.

## Revendications

1. Réseau (10) de résonateurs couplés ($16_i$ ; $16_{i,j}$) comportant des moyens (12) de fourniture d'un signal électrique d'entrée (Ve) et des moyens (14) d'excitation électrique de N résonateurs couplés ($16_i$ ; $16_{i,j}$) du réseau à l'aide de ce signal électrique d'entrée, **caractérisé en ce que** les moyens d'excitation électrique (14) comportent :

   - pour chacun de ces N résonateurs couplés ($16_i$ ; $16_{i,j}$) :

     ■ des moyens d'actionnement ($18_i$ ; $18_{i,j}$) raccordés aux moyens (12) de fourniture du signal électrique d'entrée pour un actionnement de ce résonateur couplé en fonction du signal électrique d'entrée, et
     ■ des moyens d'amplification d'entrée à gain variable ($20_i$ ; $20_{i,j}$) de l'actionnement de ce résonateur couplé propres à ce résonateur couplé ($16_i$ ; $16_{i,j}$),

   - des moyens (22) de commande d'un réglage spécifique du gain variable de chacun des moyens d'amplification d'entrée ($20_i$ ; $20_{i,j}$).

2. Réseau (10) de résonateurs couplés ($16_i$ ; $16_{i,j}$) selon la revendication 1, dans lequel chaque résonateur ($16_i$ ; $16_{i,j}$) comporte au moins un élément vibrant choisi parmi l'un des éléments de l'ensemble constitué d'un élément de type poutre vibrant en flexion, d'un élément de type disque, plaque ou poutre vibrant en volume et d'au moins un nano fil.

3. Réseau (10) de résonateurs couplés ($16_i$ ; $16_{i,j}$) selon la revendication 1 ou 2, dans lequel les résonateurs couplés

($16_i$ ; $16_{i,j}$) sont des résonateurs électromécaniques de type NEMS ou MEMS et dans lequel les moyens d'actionnement ($18_i$ ; $18_{i,j}$) et d'amplification d'entrée à gain variable ($20_i$ ; $20_{i,j}$) de chacun desdits N résonateurs couplés ($16_i$ ; $16_{i,j}$) comportent une électrode d'excitation électrostatique dont la tension de polarisation est réglable par les moyens de commande (22).

4. Réseau (10) de résonateurs couplés ($16_i$ ; $16_{i,j}$) selon l'une quelconque des revendications 1 à 3, ce réseau de résonateurs étant générateur de N modes de résonance différents à N fréquences modales différentes, tout signal vectoriel résultant de N signaux électriques fournis par lesdits N résonateurs couplés ($16_i$ ; $16_{i,j}$) en réponse à une excitation à l'aide du signal électrique d'entrée (Ve) pouvant être exprimé en tant que combinaison linéaire de N vecteurs modaux prédéterminés exprimant chacun la réponse desdits N résonateurs couplés dans l'un des N modes de résonance, dans lequel les moyens de commande (22) sont conçus pour régler sélectivement la valeur des N gains variables des moyens d'amplification d'entrée ($20_i$ ; $20_{i,j}$) en fonction des composantes de l'un des N vecteurs modaux, notamment proportionnellement à ces composantes.

5. Réseau (10) de résonateurs couplés ($16_i$ ; $16_{i,j}$) selon l'une quelconque des revendications 1 à 4, comportant :

   - pour chacun de ces N résonateurs couplés ($16_i$ ; $16_{i,j}$), des moyens ($26_i$ ; $26_{i,j}$) de détection d'une réaction de ce résonateur couplé, en réponse à l'excitation électrique des N résonateurs couplés par le signal électrique d'entrée (Ve), et de transformation de cette réaction en un signal électrique intermédiaire,
   - des moyens (30) de regroupement des signaux électriques intermédiaires pour former un signal électrique de sortie (Vs),

   et dans lequel les moyens de détection et de transformation ($26_i$ ; $26_{i,j}$) de chacun de ces N résonateurs couplés ($16_i$ ; $16_{i,j}$) sont associés à des moyens d'amplification de sortie à gain variable ($28_i$ ; $28_{i,j}$) du signal intermédiaire qu'ils fournissent propres à ce résonateur couplé ($16_i$ ; $16_{i,j}$), ce gain variable étant spécifiquement réglable par les moyens de commande (22).

6. Réseau (10) de résonateurs couplés ($16_i$ ; $16_{i,j}$) selon les revendications 3 et 5, dans lequel les moyens de détection et de transformation ($26_i$ ; $26_{i,j}$) et les moyens d'amplification de sortie à gain variable ($28_i$ ; $28_{i,j}$) de chacun desdits N résonateurs couplés ($16_i$ ; $16_{i,j}$) comportent une électrode de détection capacitive dont la tension de détection est réglable par les moyens de commande (22).

7. Réseau (10) de résonateurs couplés ($16_i$ ; $16_{i,j}$) selon les revendications 4 et 5, dans lequel les moyens de commande (22) sont conçus pour fixer la valeur des gains variables des moyens d'amplification de sortie ($28_i$ ; $28_{i,j}$) en fonction des composantes du vecteur modal sélectionné pour fixer la valeur des gains variables des moyens d'amplification d'entrée ($20_i$ ; $20_{i,j}$), notamment proportionnellement à ces composantes.

8. Réseau (10) de résonateurs couplés ($16_i$ ; $16_{i,j}$) selon l'une quelconque des revendications 5 à 7, comportant en outre une charge capacitive (52) connectée aux moyens de regroupement (30) pour recevoir un courant transmis par ces moyens de regroupement et configurée pour que la tension à ses bornes soit représentative du signal électrique de sortie (Vs).

9. Filtre passe-bande à fréquence centrale ajustable comportant un réseau (10) de résonateurs couplés ($16_i$ ; $16_{i,j}$) selon l'une quelconque des revendications 1 à 8, conçu pour recevoir un signal à filtrer en tant que signal électrique d'entrée (Ve) du réseau de résonateurs.

10. Oscillateur à fréquence d'oscillation ajustable comportant un réseau (10) de résonateurs couplés ($16_i$ ; $16_{i,j}$) selon l'une quelconque des revendications 5 à 8 et un circuit de rétroaction (32) pour la fourniture du signal électrique d'entrée en fonction du signal électrique de sortie (Vs) du réseau de résonateurs.

**Claims**

1. An array (10) of coupled resonators ($16_i$; $16_{i,j}$) comprising means (12) for supplying an input electrical signal (Ve) and means (14) for electrically exciting N coupled resonators ($16_i$; $16_{i,j}$) of the array using this input electrical signal, **characterized in that** the electrical excitation means (14) comprise:

   - for each of these N coupled resonators ($16_{i,j}$; $16_{i,j}$):

■ actuation means ($18_i$; $18_{i,j}$) connected to the means (12) for supplying the input electrical signal for an actuation of this coupled resonator according to the input electrical signal, and
■ variable gain input amplification means ($20_i$; $20_{i,j}$) for the actuation of this coupled resonator specific to this coupled resonator ($16_i$; $16_{i,j}$),

- means (22) for controlling a specific setting of the variable gain of each of the input amplification means ($20_i$; $20_{i,j}$).

2. The array (10) of coupled resonators ($16_i$; $16_{i,j}$) as claimed in claim 1, in which each resonator ($16_i$; $16_{i,j}$) comprises at least one vibrating element selected from one of the elements of the set consisting of a beam type element vibrating flection-wise, a disk, plate or beam type element vibrating volume-wise, and at least one nanowire.

3. The array (10) of coupled resonators ($16_i$; $16_{i,j}$) as claimed in claim 1 or 2, in which the coupled resonators ($16_i$; $16_{i,j}$) are electromechanical resonators of NEMS or MEMS type, and in which the actuation means ($18_i$; $18_{i,j}$) and variable gain input amplification means ($20_i$; $20_{i,j}$) of each of said N coupled resonators ($16_i$; $16_{i,j}$) comprise an electrostatic excitation electrode, the bias voltage of which is set by the control means (22).

4. The array (10) of coupled resonators ($16_i$; $16_{i,j}$) as claimed in any one of claims 1 to 3, since this array of resonators generates N different resonance modes at N different modal frequencies, since any vector signal resulting from N electrical signals supplied by said N coupled resonators ($16_i$; $16_{i,j}$) in response to an excitation using the input electrical signal (Ve) can be expressed as a linear combination of N predetermined modal vectors each expressing the response of said N coupled resonators in one of the N resonance modes, in which the control means (22) are designed to selectively set the values of the N variable gains of the input amplification means ($20_i$; $20_{i,j}$) according to the components of one of the N modal vectors, notably proportionally to these components.

5. The array (10) of coupled resonators ($16_i$; $16_{i,j}$) as claimed in any one of claims 1 to 4, comprising:

- for each of these N coupled resonators ($16_i$; $16_{i,j}$), means ($26_i$; $26_{i,j}$) for detecting a reaction of this coupled resonator, in response to the electrical excitation of the N coupled resonators by the input electrical signal (Ve), and for transforming this reaction into an intermediate electrical signal,
- means (30) for grouping together the intermediate electrical signals to form an output electrical signal (Vs),

and in which the detection and transformation means ($26_i$; $26_{i,j}$) of each of these N coupled resonators ($16_i$; $16_{i,j}$) are associated with variable gain output amplification means ($28_i$; $28_{i,j}$) of the intermediate signal that they supply specific to this coupled resonator ($16_i$; $16_{i,j}$), this variable gain being specifically able to be set by the control means (22).

6. The array (10) of coupled resonators ($16_i$; $16_{i,j}$) as claimed in claims 3 and 5, in which the detection and transformation means ($26_i$; $26_{i,j}$) and the variable gain output amplification means ($28_i$; $28_{i,j}$) of each of said N coupled resonators ($16_i$; $16_{i,j}$) comprise a capacitive detection electrode, the detection voltage of which can be set by the control means (22).

7. The array (10) of coupled resonators ($16_i$; $16_{i,j}$) as claimed in claims 4 and 5, in which the control means (22) are designed to set the value of the variable gains of the output amplification means (28i; $28_{i,j}$) according to the components of the selected modal vector to set the values of the variable gains of the input amplification means (20i; 20i,j), notably proportionally to these components.

8. The array (10) of coupled resonators ($16_i$; $16_{i,j}$) as claimed in any one of claims 5 to 7, further comprising a capacitive load (52) connected to the grouping means (30) to receive a current transmitted by these grouping means and configured so that the voltage at its terminals is representative of the output electrical signal (Vs).

9. A bandpass filter with tunable center frequency comprising an array (10) of coupled resonators ($16_i$; $16_{i,j}$) as claimed in any one of claims 1 to 8, designed to receive a signal to be filtered as input electrical signal (Ve) of the array of resonators.

10. An oscillator with tunable oscillation frequency comprising an array (10) of coupled resonators ($16_i$; $16_{i,j}$) as claimed in any one of claims 5 to 8 and a feedback circuit (32) to supply the input electrical signal according to the output electrical signal (Vs) of the array of resonators.

**Patentansprüche**

1. Netzwerk (10) aus gekoppelten Resonatoren ($16_i$; $16_{i,j}$), mit Mitteln (12) zum Liefern eines elektrischen Eingangssignals (Ve) und Mitteln (14) zum elektrischen Erregen von N gekoppelten Resonatoren ($16_i$; $16_{i,j}$) des Netzwerks mit Hilfe dieses elektrischen Eingangssignals, **dadurch gekennzeichnet, dass** die elektrischen Erregungsmittel (14) umfassen:

   - für jeden dieser N gekoppelten Resonatoren ($16_i$; $16_{i,j}$):

      ♦ Betätigungsmittel ($18_i$; $18_{i,j}$), die mit den Mitteln (12) zum Liefern des elektrischen Eingangssignals verbunden sind, um diesen gekoppelten Resonator als Funktion des elektrischen Eingangssignals zu betätigen, und
      ♦ Eingangsverstärkungsmittel ($20_i$; $20_{i,j}$) mit variabler Verstärkung für die Betätigung dieses gekoppelten Resonators, die zu diesem gekoppelten Resonator ($16_i$; $16_{i,j}$) gehören,

   - Steuermittel (22) für eine spezifische Regulierung der variablen Verstärkung jedes der Eingangsverstärkungsmittel ($20_i$; $20_{i,j}$).

2. Netzwerk (10) aus gekoppelten Resonatoren ($16_i$; $16_{i,j}$) nach Anspruch 1, wobei jeder Resonator ($16_i$; $16_{i,j}$) wenigstens ein vibrierendes Element enthält, das aus einem der Elemente der Gesamtheit gewählt ist, die aus einem Element des Typs Träger, der biegend vibriert, einem Element des Typs Scheibe, Platte oder Träger, deren bzw. dessen Volumen vibriert, und wenigstens einem Nanodraht gebildet ist.

3. Netzwerk (10) aus gekoppelten Resonatoren ($16_i$; $16_{i,j}$) nach Anspruch 1 oder 2, wobei die gekoppelten Resonatoren ($16_i$; $16_{i,j}$) elektromechanische Resonatoren des NEMS- oder MEMS-Typs sind und wobei die Betätigungsmittel ($18_i$; $18_{i,j}$) und die Eingangsverstärkungsmittel ($20_i$; $20_{i,j}$) mit variabler Verstärkung jedes dieser N gekoppelten Resonatoren ($16_i$; $16_{i,j}$) eine elektrostatische Erregungselektrode enthalten, deren Vorspannung durch die Steuermittel (22) regulierbar ist.

4. Netzwerk (10) aus gekoppelten Resonatoren ($16_i$; $16_{i,j}$) nach einem der Ansprüche 1 bis 3, wobei dieses Resonatornetzwerk ein Generator für N verschiedene Resonanzschwingungsmoden mit N verschiedenen Schwingungsmodenfrequenzen ist, wobei jedes Vektorsignal, das aus N elektrischen Signalen resultiert, die von den N gekoppelten Resonatoren ($16_i$; $16_{i,j}$) in Ansprechen auf eine Erregung mit Hilfe des elektrischen Eingangssignals (Ve) geliefert werden, als Linearkombination von N vorgegebenen Schwingungsmodenvektoren ausgedrückt werden kann, die jeweils die Antwort der N gekoppelten Resonatoren in einer der N Resonanzschwingungsmoden angeben, wobei die Steuermittel (22) dazu ausgelegt sind, wahlweise den Wert der N variablen Verstärkungen der Eingangsverstärkungsmittel ($20_i$; $20_{i,j}$) als Funktion der Komponenten eines der N Schwingungsmodenvektoren insbesondere proportional zu diesen Komponenten zu regulieren.

5. Netzwerk (10) aus gekoppelten Resonatoren ($16_i$; $16_{i,j}$) nach einem der Ansprüche 1 bis 4, das umfasst:

   - für jeden dieser N gekoppelten Resonatoren ($16_i$; $16_{i,j}$) Mittel ($26_i$; $26_{i,j}$) zum Detektieren einer Reaktion dieses gekoppelten Resonators in Ansprechen auf die elektrische Erregung der N gekoppelten Resonatoren durch das elektrische Eingangssignal (Ve) und zum Transformieren dieser Reaktion in ein elektrisches Zwischensignal,
   - Mittel (30) zum Umgruppieren der elektrischen Zwischensignale, um ein elektrisches Ausgangssignal (Vs) zu bilden,

   und wobei den Detektions- und Transformationsmitteln ($26_i$; $26_{i,j}$) jedes dieser N gekoppelten Resonatoren ($16_i$; $16_{i,j}$) Ausgangsverstärkungsmittel ($28_i$; $28_{i,j}$) mit variabler Verstärkung des Zwischensignals das sie liefern zugeordnet sind, die zu diesem gekoppelten Resonator ($16_i$; $16_{i,j}$) gehören, wobei diese variable Verstärkung durch die Steuermittel (22) spezifisch regulierbar ist.

6. Netzwerk (10) aus gekoppelten Resonatoren ($16_i$; $16_{i,j}$) nach den Ansprüchen 3 und 5, wobei die Detektions- und Transformationsmittel ($26_i$; $26_{i,j}$) und die Ausgangsverstärkungsmittel ($28_i$; $28_{i,j}$) mit variabler Verstärkung jedes der N gekoppelten Resonatoren ($16_i$; $16_{i,j}$) eine kapazitive Detektionselektrode enthalten, deren Detektionsspannung durch die Steuermittel (22) regulierbar ist.

7. Netzwerk (10) aus gekoppelten Resonatoren ($16_i$; $16_{i,j}$) nach den Ansprüchen 4 und 5, wobei die Steuermittel (22) dazu ausgelegt sind, den Wert der variablen Verstärkungen der Ausgangsverstärkungsmittel ($28_i$; $28_{i,j}$) als Funktion der Komponenten des gewählten Schwingungsmodenvektors festzulegen, um den Wert der variablen Verstärkungen der Eingangsverstärkungsmittel ($20_i$; $20_{i,j}$) insbesondere proportional zu diesen Komponenten festzulegen.

8. Netzwerk (10) aus gekoppelten Resonatoren ($16_i$; $16_{i,j}$) nach einem der Ansprüche 5 bis 7, das außerdem eine kapazitive Last (52) umfasst, die mit den Umgruppierungsmitteln (30) verbunden ist, um einen von diesen Umgruppierungsmitteln übertragenen Strom zu empfangen, und konfiguriert ist, damit die Spannung an ihren Anschlüssen das elektrische Ausgangssignal (Vs) repräsentiert.

9. Bandpassfilter mit einstellbarer Mittenfrequenz, das ein Netzwerk (10) aus gekoppelten Resonatoren ($16_i$; $16_{i,j}$) nach einem der Ansprüche 1 bis 8 enthält und dazu ausgelegt ist, ein zu filterndes Signal als elektrisches Eingangssignal (Ve) des Resonatornetzwerks zu empfangen.

10. Oszillator mit einstellbarer Oszillationsfrequenz, der ein Netzwerk (10) aus gekoppelten Resonatoren ($16_i$; $16_{i,j}$) nach einem der Ansprüche 5 bis 8 und eine Rückkopplungsschaltung (32) zum Liefern des elektrischen Eingangssignals als Funktion des elektrischen Ausgangssignals (Vs) des Resonatornetzwerks umfasst.

## Figure 1

## Figure 2

### Figure 3a

### Figure 3b

### Figure 3c

### Figure 4a

### Figure 4b

## Figure 5

## Figure 6

## Figure 7

## Figure 9

## Figure 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2001030489 A1

**Littérature non-brevet citée dans la description**

- **S. Lee ; C. Nguyen.** Mechanically-Coupled Micromechanical Resonator Arrays for Improved Phase Noise. *2004 IEEE International Ultrasonics, Ferroelectrics, and Frequency Control Joint 50th Anniversary Conference,* 2004

- **S. Li ; Y. Lin ; Z. Ren ; C. Nguyen.** An MSI Micromechanical Differential Disk-array Filter. *Dig. Of Tech. Papers, 14th International Conference on Solid-State Sensors and actuators (Transducers '07),* 11 Juin 2007, 307-311
- **H. Chandrahalim ; S. Bhave.** Digitally-tunable MEMS filter using Mechanically-Coupled Resonator Array. *21 st IEEE International Conference on Micro Electro Mechanical Systems,* 13 Janvier 2008